(19) Europäisches Patentamt
European Patent Office
Office européen des brevets

(11) **EP 4 160 923 A1**

(12) **EUROPEAN PATENT APPLICATION**

(43) Date of publication:
**05.04.2023 Bulletin 2023/14**

(21) Application number: **21200538.3**

(22) Date of filing: **01.10.2021**

(51) International Patent Classification (IPC):
*H03K 17/972* *(2006.01)* *H03K 17/97* *(2006.01)*

(52) Cooperative Patent Classification (CPC):
**H03K 17/972;** H03K 2017/9706; H03K 2217/9651

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Vestel Elektronik Sanayi ve Ticaret A.S.**
**45030 Manisa (TR)**

(72) Inventor: **YALIN, Nevzat**
**45030 Manisa (TR)**

(74) Representative: **Flint, Adam et al**
**Page White & Farrer Limited**
**Bedford House**
**21A John Street**
**London WC1N 2BF (GB)**

(54) **BUTTON ARRANGEMENT AND METHOD OF OPERATION**

(57) A button arrangement (100) for controlling an appliance comprises a coil (110) at which an inductive response can be detected, a first button (130a), a second button (130b), and a controller (200). When the first button (130a) is actuated, the inductive response at the coil (110) is a first inductive response. When the second button (130b) is actuated, the inductive response at the coil (110) is a second inductive response which is different from the first inductive response. The controller (200) detects a change in the inductive response of the coil (110) corresponding to actuation of one or more of the buttons (130a, 130b), determines, based on said detection, which one or more of the buttons (130a, 130b) has been actuated, and generates an output to control the appliance in accordance with the determined actuated one or more of the buttons (130a, 130b).

Figure 1a

**Description**

Technical Field

The present disclosure relates to a button arrangement for controlling an appliance, and a method of operating a button arrangement to control an appliance.

Background

Many appliances are operable via actuatable buttons, typically each being associated with different functionality of the appliance. For example, actuation of each button may be interpreted by a controller of the appliance in a different way (which may depend on a current state of the appliance).

In many cases, it is important to electrically isolate the buttons from the rest of the appliance e.g. if the appliance comprises a non-isolated power supply. This is common in white goods appliances, for example, where non-isolated power supplies are often used for cost efficiency reasons. Isolation can be important to ensure proper functioning of the appliance, for safety reasons, and also as a form of corrosion control.

Summary

According to a first aspect disclosed herein, there is provided a button arrangement for controlling an appliance, the button arrangement comprising: a coil at which an inductive response can be detected; a first button constructed and arranged such that, when the first button is actuated, the inductive response at the coil is a first inductive response; a second button constructed and arranged such that, when second button is actuated, the inductive response at the coil is a second inductive response which is different from the first inductive response; and a controller configured to: detect a change in the inductive response of the coil corresponding to actuation of one or more of the buttons; determine, based on said detection, which one or more of the buttons has been actuated; and generate an output to control the appliance in accordance with the determined actuated one or more of the buttons.

The at least one coil may form part of a circuit having a measurable property which depends on the inductance of the at least one coil. The controller may be configured to determine the inductive response by observing changes to this measurably property. Examples of measurable properties include the resonant frequency of the circuit (e.g. an LC tank circuit) and the magnitude of an alternating current or voltage induced in the at least one coil by a second coil.

In an example, the buttons are constructed and arranged to cause the different inductive responses by being constructed of a different respective material or combination of materials.

In an example, the buttons are constructed and arranged to cause the different inductive responses by having a different respective geometry.

In an example, the buttons are constructed and arranged to cause the different inductive responses by being arranged to move a different respective distance upon actuation.

In an example, the buttons are constructed and arranged to cause the different inductive responses by having a different respective distance from the coil at the completion of actuation (when the button is in the (fully) actuated state).

In an example, the controller is configured to determine the actuated one or more of the buttons using a lookup table which stores for each button, and optionally one or more combinations of buttons, an expected inductive response detectable via the coil when the button is actuated.

In an example, each button comprises an electrically insulating surface for contact by a user to actuate the button. An example of an electrically insulating surface is a plastics surface.

In an example, the buttons are constructed and arranged such that simultaneous actuation of any two or more of the buttons causes a combined inductive response which is different from the first inductive response and different from the second inductive response.

In an example, the button arrangement comprises a third button constructed and arranged such that, when the third button is actuated, the inductive response at the coil is a third inductive response which is different from both the first inductive response and the second inductive response. In examples, there may be four buttons, five buttons, or more. For any number of buttons, the buttons may be constructed and arranged such that simultaneous actuation of any two or more buttons causes a combined inductive response which is different from the inductive response caused by each button individually. Generally, the buttons may be actuatable individually or in combinations. The buttons may be constructed and arranged such that simultaneous actuation of any one button or combination of two or more buttons causes a different respective inductive response.

In an example, the controller is configured to detect the inductive response at the coil by measuring a signal from the coil, and the controller is configured to apply at least one filter to the measured signal. Examples of filters include an average or median filter, a low-pass filter, etc.

In an example, the at least one coil is a sensing coil, the button arrangement comprises a driving coil, and the controller is configured to: cause the driving coil to be driven with an alternating signal to cause a response signal to be generated in the sensing coil via mutual inductance; measure a magnitude of the response signal generated in the sensing coil; and detect the inductive response based on the measured magnitude of the response signal.

In an example, the coil forms part of a circuit having a resonant frequency which depends on the inductance of the coil, and the controller is configured to detect the inductive response at the coil based on measuring said resonant frequency. For example, the coil may form part of an LC tank circuit, the resonant frequency of which depends on the inductance of the coil (which is affected by actuation of the buttons).

According to a second aspect disclosed herein, there is provided a white goods appliance having the button arrangement of the first aspect or any example thereof. White goods appliances may also be referred to as "major appliances", or "large domestic appliances". Examples of white goods appliances include washing machines, dishwashers, refrigerators, clothes dryers, air conditioners, etc.

According to a third aspect disclosed herein, there is provided a method of operating a button arrangement to control an appliance, the button arrangement comprising: a coil at which an inductive response can be detected; a first button constructed and arranged such that, when the first button is actuated, the inductive response at the coil is a first inductive response; and a second button constructed and arranged such that, when second button is actuated, the inductive response at the coil is a second inductive response which is different from the first inductive response; the method comprising: detecting a change in the inductive response of the coil corresponding to actuation of one or more of the buttons; determining, based on said detection, which one or more of the buttons has been actuated; and generating an output to control the appliance in accordance with the determined actuated one or more of the buttons.

Brief Description of the Drawings

To assist understanding of the present disclosure and to show how embodiments may be put into effect, reference is made by way of example to the accompanying drawings in which:

Figures 1a and 1b show schematically a side view and a top view, respectively, of an example of a button arrangement in accordance with an embodiment of the present disclosure;

Figures 2a-d shows schematically examples of different button constructions;

Figure 3 shows schematically an example of buttons with caps;

Figure 4 shows schematically a flow chart of an example method performed by a controller;

Figure 5 shows schematically an example of a button arrangement in accordance with an embodiment of the present disclosure comprising a single coil; and

Figure 6 shows schematically an example of a button arrangement in accordance with an embodiment of the present disclosure comprising two coils.

Detailed Description

According to examples described herein, a button arrangement for controlling an appliance comprises a coil, at least two buttons, and a controller. In examples, there may be three or more buttons. In examples, there may be a single coil or a single pair of coils, depending on for example the specific arrangement used and, in particular, the particular circuit in which the coil or coils is incorporated and the corresponding property that is being measured in practice to determine which button or combination of buttons has been actuated. The appliance may be a white goods appliance (also known as "major appliances", or "large domestic appliances"). Examples of white goods appliances include washing machines, dishwashers, refrigerators, clothes dryers, air conditioners, etc.

Each button is constructed and arranged, so as when actuated, to provide a different respective inductive response via the (same) coil. That is, actuation of each button causes a different change in the inductance of the coil. By detecting changes to the inductance of the coil caused by actuation of the buttons, the controller can determine which one or more of the buttons has been actuated.

There are various ways in which changes to the inductance of the coil made be detected. In an example, the coil forms part of a circuit (such as an LC tank circuit) having a resonant frequency that depends on the inductance of the coil. Changes to the inductance of the coil can therefore be detected by observing changes to the resonant frequency of the circuit, which occur when a button is actuated so as to be moved closer to the coil. In another example, an alternating current at a second coil induces an alternating current in the (first) coil via mutual inductance, the magnitude of which depends, at least in part, on the inductance of the first coil. Changes to the inductance of the first coil can therefore be detected by observing changes to the magnitude of the induced alternating current at the first coil.

The controller generates an output indicative of the determined actuated one or more of the buttons. The output generated by the controller may be used for controlling the appliance. The buttons may be associated, for example, with different functionalities or control commands of the appliance which is controlled by the button arrangement.

Because the same coil or pair of coils (and associated circuitry) is used for multiple buttons, rather than requiring a respective coil or pair of coils for each button, the button arrangement can be made smaller, simpler, and cheaper.

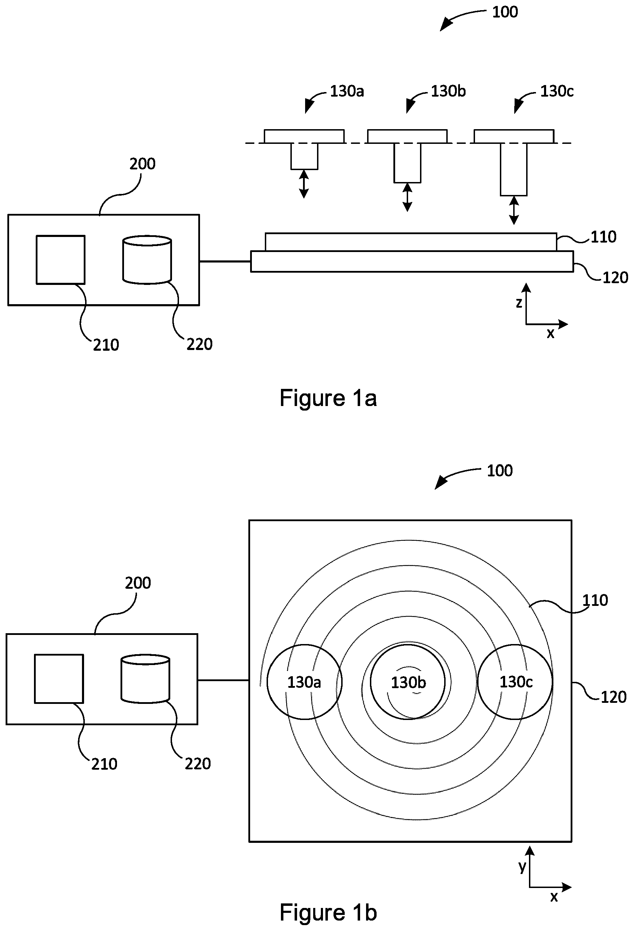

Figures 1a and 1b show schematically a side view and a top view, respectively, of a button arrangement 100 in accordance with an example described herein. The button arrangement 100 comprises at least one coil 110, a plurality of buttons 130, and a controller 200. The at least one coil 110 may be located on a printed circuit board (PCB) 120 as shown in Figures 1a and 1b.

The controller 200 is operatively coupled to the at least one coil 110. The controller 200 may be implemented in hardware, software, or a combination of hardware and software. In this example, the controller 200 comprises a processor 210 and a memory 220. Hardware of the controller 200 may be partially or wholly located on the PCB 120 with the at least one coil 110, or may be separate from the PCB 120 as shown in Figures 1a and 1b (e.g. on a separate PCB, not shown).

In this example, the button arrangement 100 comprises three buttons 130: a first button 130a, a second button 130b, and a third button 130c. In other examples, there may be a different number of buttons (i.e. two, or four or more).

For reference, a right-handed coordinate system is introduced, with the at least one coil 110 lying in the x-y plane and the buttons 130 being located above the at least one coil 110 in the positive z-direction.

Each button 130 is independently actuatable by a user to move the button 130 from an unactuated state to an actuated state. In the example shown, the actuated state, the button 130 is located closer to the at least one coil 110 than in the unactuated state (though the converse arrangement may alternatively be used in which in the unactuated state, the button 130 is located closer to the at least one coil 110 than in the actuated state). The buttons 130 in Figure 1a are shown in their unactuated positions, with arrows indicating the direction of motion ("up and down" in the negative and positive z-direction, respectively). Actuation of a button 130 may, for example, involve the user pressing the top of the button 130. It is appreciated that there may be additional hardware not shown in the figures for determining or controlling movement of the buttons 130. For example, the button arrangement 100 may comprise a button guide such as a channel or conduit for constraining movement of the buttons 130 (e.g. so each button 130 can move in the z-direction but not the x-direction or y-direction), and optionally stops or ridges constraining motion of the buttons 130 in the z-direction to being between the higher, unactuated position and the lower, actuated position. In an example, the button arrangement 100 may comprise a biasing member, such as a coil spring or the like, for returning the buttons 130 to the unactuated state.

The at least one coil 110 is constructed of an electrically conductive material (e.g. metal) and acts as an inductor. In accordance with the laws of electromagnetism, the inductance of the at least one coil 110 is affected by nearby objects. Specifically, the magnetic permeability of a nearby object, the position of the nearby object relative to the at least one coil 110, and the geometry of the nearby object itself can all have an effect on the inductance of the at least one coil 110. In the button arrangement 100 described herein, this means that the inductance of the at least one coil 110 is affected by activation of a button 130, which moves the button 130 closer to the at least one coil 110 in this example. The change in inductance of the at least one coil 110 caused by actuation of a particular button 130 will be referred to as the "inductive response" provided by that button 130.

In accordance with the present disclosure, each button 130 is actuatable to provide a different respective inductive response. That is, the buttons 130 are constructed and arranged such that they each produce a measurably different change in the inductance of the at least one coil 110 when actuated. This can be achieved in different ways:

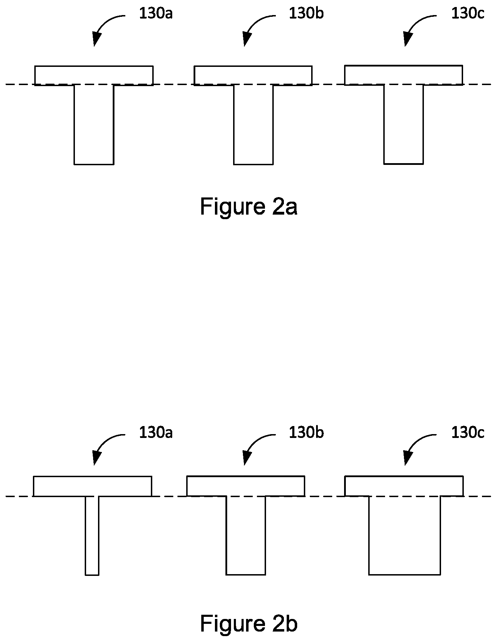

- Figure 2a shows a first example in which the buttons 130 are each constructed of a different material (e.g. different metals having different magnetic permeabilities or combinations of different materials having different magnetic permeabilities);
- Figure 2b shows a second examples in which the buttons 130 each have a different geometry (e.g. a different size, area, shape, volume, etc.);

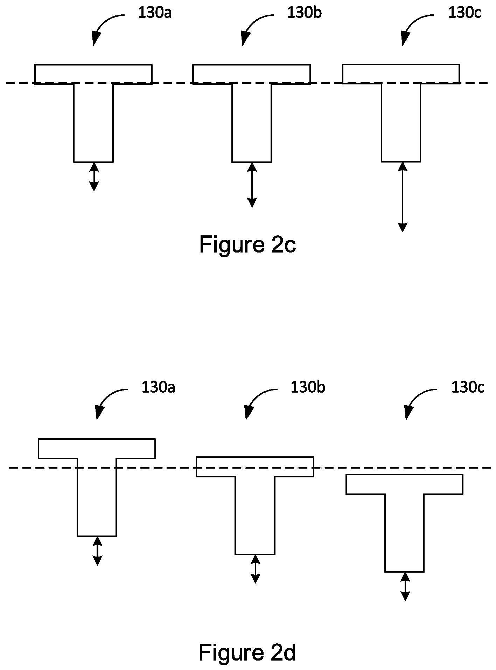

- Figure 2c shows a third example in which the buttons 130 are each arranged to move a different distance towards the at least one coil 110 upon actuation; and/or
- Figure 2d shows a fourth example in which the buttons 130 each have a different distance from the at least one coil 110 (e.g. in the final, fully actuated position).

It is appreciated that the examples given above are example properties of the buttons 130 which affect the inductive response of the buttons 130. These properties may be used separately or in combination. For example, the buttons 130 may vary in both shape and material.

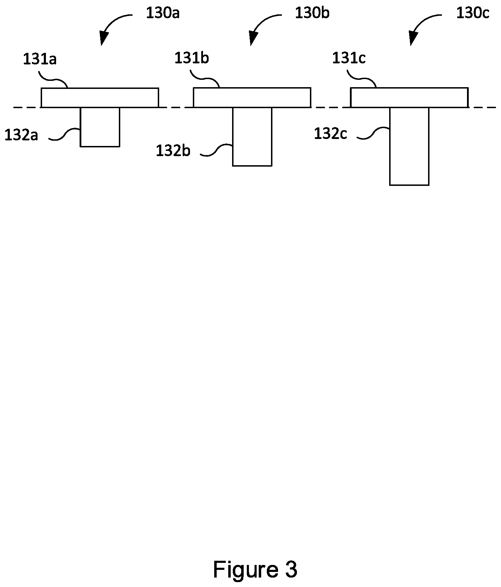

In some examples, as shown in Figure 3, each button 130 comprises a cap 131 and an inductive portion 132. The caps 131 may be constructed of an electrically insulating material (e.g. plastics). The cap 131 may be e.g. approximately 4-6mm thick. In such cases, the inductive portion 132 of the button 130 is the part which is varied in order to achieve the different inducive responses.

In operation, the controller 200 determines which one or more of the buttons 130 has been actuated based on detecting changes in inductance of the at least one coil 110 (i.e. the inductive response corresponding to actuation of one or more of the buttons 130) and relating that to the specific one or more of the buttons 130 that has or have been actuated. This change in inductance may be measured indirectly by the controller 200 (e.g. by measuring another property which depends on the inductance of the at least one coil 110). The controller 200 then generates an output indicative of the actuated one or more of the buttons 130.

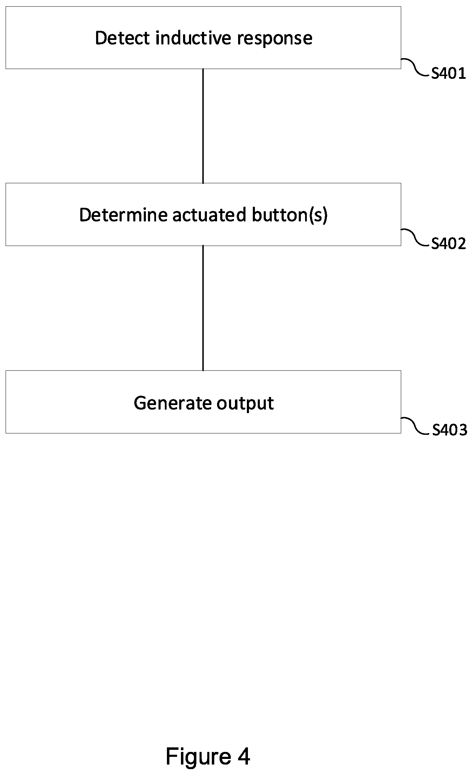

Figure 4 shows a method performed by the controller 200.

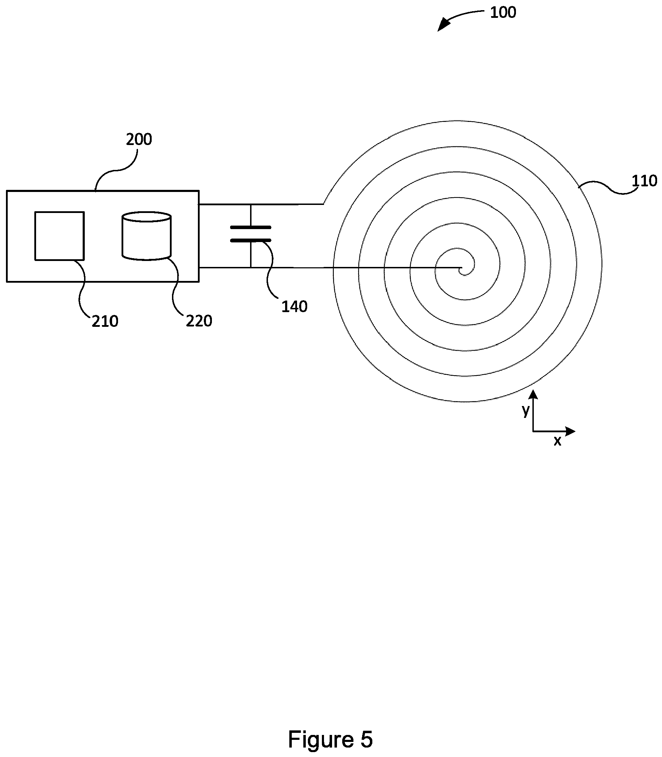

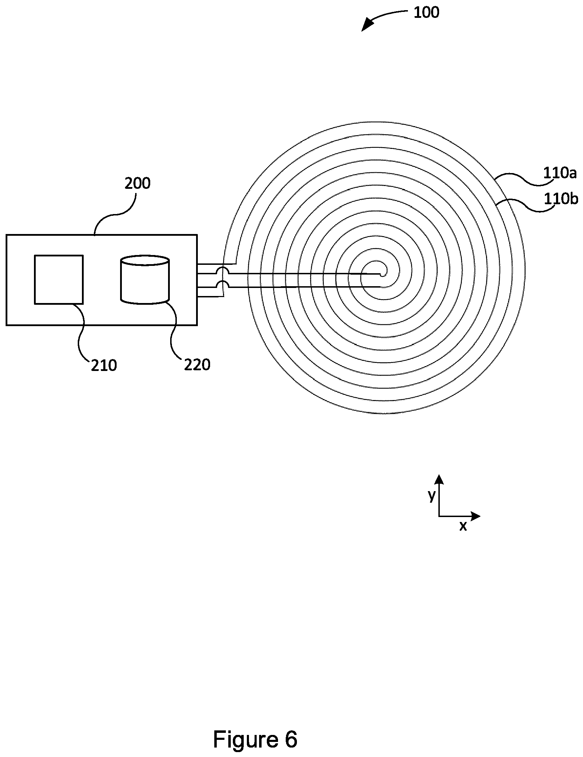

At S401, the controller 200 detects an inductive response provided at the at least one coil 110 corresponding to actuation of one or more of the buttons 130. The controller 200 may achieve this in a number of different ways. Examples are given below in relation to Figures 5 and 6.

At S402, the controller 200 determines, based on the detected inductive response, which one or more of the buttons 130 has been actuated. The controller 200 may determine the actuated one or more of the buttons 130 using a lookup table storing indications of the inductive response measurable for actuation of different buttons 130. An example lookup table is shown in Table 1. "0" indicates a button that is not actuated, and "1" indicates a button that is actuated.

Table 1

| First button 130a | Second button 130b | Third button 130c | Inductive Response (arbitrary units) |
| --- | --- | --- | --- |
| 0 | 0 | 0 | 0 |
| 1 | 0 | 0 | 1 |
| 0 | 1 | 0 | 2 |
| 0 | 0 | 1 | 3 |

The lookup table may be stored in memory 220, or in another memory location accessible to the controller 200. The controller 200 may access the memory 220 (or other memory location) to read the lookup table and thereby identify which one or more buttons 130 have been actuated based on the inductive response detected at S401. The lookup table may be configured, e.g. during a prior, commissioning stage, by selectively actuating different ones of the buttons 130 and recording the resulting inductive response.

In some examples, the buttons 130 are constructed and arranged such that the combined inductive response resulting from simultaneous actuation of any two or more of the buttons 130 is also different. With three buttons, for example, there are eight different combinations, which may each result in a different inductive response (see Table 2 below).

Table 2

| First button 130a | Second button 130b | Third button 130c | Inductive Response (arbitrary units) |
| --- | --- | --- | --- |
| 0 | 0 | 0 | 0 |
| 1 | 0 | 0 | 1 |
| 0 | 1 | 0 | 2 |
| 1 | 1 | 0 | 4 |
| 0 | 0 | 1 | 3 |
| 1 | 0 | 1 | 5 |
| 0 | 1 | 1 | 6 |
| 1 | 1 | 1 | 7 |

At S403, the controller 200 generates an output indicative of the actuated one or more of the buttons 130. The output is for controlling the appliance in accordance with the determined one or more buttons 130.

As mentioned, the controller 200 may detect at S401 an inductive response provided at the at least one coil 110 corresponding to actuation of one or more of the buttons 130 in a number of different ways. Examples are shown in Figures 5 and 6.

In the example of Figure 5, the at least one coil 110 is a single planar coil (e.g. a flat spiral as shown in Figure 1b). This example can provide improved electric isolation, and may also be smaller, simpler, and/or cheaper than other examples comprising two coils 110, such as the example of Figure 6 below.

Specifically, in Figure 5, the single coil 110 is arranged in parallel with a capacitor 140 to form an LC tank circuit. The resonant frequency f of the LC tank circuit depends on the inductance L of the coil 110 and the capacitance C of the capacitor 140 in accordance with Equation 1:

$$f = \frac{1}{2\pi\sqrt{LC}}$$

Equation 1

As an electrically conductive target (a button 130) approaches the inductive coil 110, eddy currents form on the surface of the conductive target. The magnetic field of these eddy currents resist the current of the inductive coil 110, which reduces the inductance of the system and increases the resonant frequency of the circuit.

The controller 200 may drive the LC tank circuit and detect the resonant frequency of the LC tank circuit. For example, the controller 200 may comprise an oscillator for driving the LC tank circuit and circuitry for detecting the resonant frequency of the LC tank circuit. By sensing the resonant frequency of the LC tank circuit, and observing changes to the resonant frequency, the controller 200 can determine the inductive response provided by actuation of one or more of the buttons 130.

In examples, the controller 200 may calculate the inductive response based on the measured resonant frequency, and then determine the actuated one or more of the buttons 130 (e.g. using a lookup table such as shown in Tables 1 and 2). In other examples, the controller 200 may use the measured resonant frequency directly to determine the actuated one or more of the buttons 130. For example, a lookup table similar to Table 1 or 2 may be used, but storing resonant frequency values for different button combinations, rather than inductive response values. Such resonant frequency values may also be determined during a prior, commissioning stage and stored in the lookup table.

In the example of Figure 6, there are two coils: a driving coil 110a and a sensing coil 110b. The example of Figure 6 can provide better sensitivity with regard to distinguishing between different inductive responses than the example of Figure 5.

The driving coil 110a and sensing coil 110b are arranged such that they interact via mutual inductance. Mutual inductance refers to the effect of the magnetic field generated by one coil (the driving coil 110a) on the other coil (the sensing coil 110b) to induce a voltage into the other coil. The strength of the mutual inductance depends on the relative position and spacing of the coils 110a, 110b, as well as nearby objects (i.e. the buttons 130 in the button arrangement 100). In an example, the driving coil 110a and sensing coil 110b may be co-located planar coils as shown in Figure 6, which provides for efficient transfer of energy, or may be magnetically linked in some other manner.

In operation of this example, the controller 200 drives the driving coil 110a with a drive signal (e.g. a sine wave having a frequency f, such as for example in the range approximately 100kHz-500kHz). In response, due to mutual inductance, a response signal will be generated in the sensing coil 110b, e.g. a sine wave having the same frequency f and a given magnitude. The strength (magnitude of the voltage) of the signal from the sensing coil 110b depends on the strength of the mutual inductance.

Let, for example, the current applied to the driving coil 110a by the controller 200 be ii, the inductance of the driving coil 110a be Li, the inductance of the sensing coil 110b be $L_2$, the induced current in the sensing coil 110b be $i_2$, and the mutual inductance of the two coils 110a, 110b be M. The induced voltage $V_2$ at the sensing coil 110b will be:

$$V_2 = L_2 \frac{di_2}{dt} \pm M \frac{di_1}{dt}$$

Equation 2

The mutual inductance M of the two coils 110a, 110b, and therefore the magnitude of the induced voltage $V_2$ generated in the sensing coil 110b, is affected by the positions of the buttons 130 relative to the coils 110a, 110b. In the same manner as described above, each button 130 is constructed and arranged to cause a different change to the mutual inductance (via their geometry, material, positioning, etc.). Therefore, actuation of each of the buttons 130, and in an example different combinations of buttons 130, causes a different change to the magnitude of the response signal.

The controller 200 is configured to measure the magnitude of the induced voltage and use this to identify which one or more of the buttons 130 has been actuated. The controller 200 may be configured to apply a filter to the measured voltage. For example, the controller 200 may apply an average or median filter, a low-pass filter, etc. to smooth and linearize the measured voltage.

As above, the controller 200 may identify which buttons 130 have been actuated using a lookup table by either calculating the inductive response or by using a lookup table that stores associations between different combinations of one or more button actuations and their respective expected induced voltage magnitude.

It will be understood that the processor or processing system or circuitry referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors, a digital signal processor or processors, baseband circuitry and radio frequency circuitry, which are configurable so as to operate in accordance with the exemplary embodiments. In this regard, the exemplary embodiments may be implemented at least in part by computer software stored in (non-transitory) memory and executable by the processor, or by hardware, or by a combination of tangibly stored software and hardware (and tangibly stored firmware).

Reference is made herein to data storage for storing data. This may be provided by a single device or by plural devices. Suitable devices include for example a hard disk and non-volatile semiconductor memory (including for example a solid-state drive or SSD).

Although at least some aspects of the embodiments described herein with reference to the drawings comprise computer processes performed in processing systems or processors, the invention also extends to computer programs, particularly computer programs on or in a carrier, adapted for putting the invention into practice. The program may be in the form of non-transitory source code, object code, a code intermediate source and object code such as in partially compiled form, or in any other non-transitory form suitable for use in the implementation of processes according to the invention. The carrier may be any entity or device capable of carrying the program. For example, the carrier may comprise a storage medium, such as a solid-state drive (SSD) or other semiconductor-based RAM; a ROM, for example a CD ROM or a semiconductor ROM; a magnetic recording medium, for example a floppy disk or hard disk; optical memory devices in general; etc.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

**Claims**

1. A button arrangement (100) for controlling an appliance, the button arrangement (100) comprising:

   a coil (110) at which an inductive response can be detected;
   a first button (130a) constructed and arranged such that, when the first button (130a) is actuated, the inductive response at the coil (110) is a first inductive response;
   a second button (130b) constructed and arranged such that, when second button (130b) is actuated, the inductive response at the coil (110) is a second inductive response which is different from the first inductive response; and
   a controller (200) configured to:

   detect a change in the inductive response of the coil (110) corresponding to actuation of one or more of the buttons (130a, 130b);
   determine, based on said detection, which one or more of the buttons (130a, 130b) has been actuated; and
   generate an output to control the appliance in accordance with the determined actuated one or more of the buttons (130a, 130b).

2. A button arrangement (100) according claim 1, wherein the buttons (130a, 130b) are constructed and arranged to cause the different inductive responses by being constructed of a different respective material or combination of materials.

3. A button arrangement (100) according claim 1 or claim 2, wherein the buttons (130a, 130b) are constructed and arranged to cause the different inductive responses by having a different respective geometry.

4. A button arrangement (100) according any of claims 1 to 3, wherein the buttons (130a, 130b) are constructed and arranged to cause the different inductive responses by being arranged to move a different respective distance upon actuation.

5. A button arrangement (100) according any of claims 1 to 4, wherein the buttons (130a, 130b) are constructed and arranged to cause the different inductive responses by having a different respective distance from the coil (110) at the completion of actuation.

6. A button arrangement (100) according any of claims 1 to 5, wherein the controller (200) is configured to determine the actuated one or more of the buttons (130a, 130b) using a lookup table which stores for each button, and optionally one or more combinations of buttons, an expected inductive response detectable via the coil (110) when the button is actuated.

7. A button arrangement (100) according to any of claims 1 to 6, wherein each button (130a, 130b) comprises an electrically insulating surface for contact by a user to actuate the button (130a, 130b).

8. A button arrangement (100) according any of claims 1 to 7, wherein the buttons (130a, 130b) are constructed and arranged such that simultaneous actuation of any two or more of the buttons (130a, 130b) causes a combined inductive response which is different from the first inductive response and different from the second inductive response.

9. A button arrangement (100) according any of claims 1 to 8, comprising a third button (130c) constructed and arranged such that, when the third button (130c) is actuated, the inductive response at the coil (110) is a third inductive response which is different from both the first inductive response and the second inductive response .

10. A button arrangement (100) according any of claims 1 to 9, wherein the controller (200) is configured to detect the inductive response at the coil (110) by measuring a signal from the coil (110), and wherein the controller (200) is configured to apply at least one filter to the measured signal.

11. A button arrangement (100) according any of claims 1 to 10, wherein the coil (110) is a sensing coil (110b), the button arrangement (100) comprising a driving coil (110a), and wherein the controller (200) is configured to:

cause the driving coil (110a) to be driven with an alternating signal to cause a response signal to be generated in the sensing coil (110b) via mutual inductance;
measure a magnitude of the response signal generated in the sensing coil (110b); and
detect the inductive response based on the measured magnitude of the response signal.

12. A button arrangement (100) according any of claims 1 to 10, wherein the coil (110) forms part of a circuit having a resonant frequency which depends on the inductance of the coil (110), and the controller (200) is configured to detect the inductive response at the coil (110) based on measuring said resonant frequency.

13. A white goods appliance having the button arrangement (100) of any of claims 1 to 12.

14. A method of operating a button arrangement (100) to control an appliance, the button arrangement (100) comprising: a coil (110) at which an inductive response can be detected; a first button (130a) constructed and arranged such that, when the first button (130a) is actuated, the inductive response at the coil (110) is a first inductive response; and a second button (130b) constructed and arranged such that, when second button (130b) is actuated, the inductive response at the coil (110) is a second inductive response which is different from the first inductive response; the method comprising:

detecting a change in the inductive response of the coil (110) corresponding to actuation of one or more of the buttons (130a, 130b);
determining, based on said detection, which one or more of the buttons (130a, 130b) has been actuated; and
generating an output to control the appliance in accordance with the determined actuated one or more of the buttons (130a, 130b).

100

130a 130b 130c

200

210 220

110

120

z
x

Figure 1a

100

200

210 220

110

120

130a 130b 130c

y
x

Figure 1b

130a 130b 130c

Figure 2a

130a 130b 130c

Figure 2b

130a 130b 130c

Figure 2c

130a 130b 130c

Figure 2d

Figure 3

Detect inductive response

S401

Determine actuated button(s)

S402

Generate output

S403

Figure 4

Figure 5

Figure 6

Europäisches
Patentamt

European
Patent Office

Office européen
des brevets

# EUROPEAN SEARCH REPORT

Application Number

EP 21 20 0538

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 4 529 967 A (GIFFT THOMAS H [US]) 16 July 1985 (1985-07-16) * column 7, line 7 - line 24; figures 1-6 * * column 6, line 11 - line 15 * | 1-14 | INV. H03K17/972 ADD. H03K17/97 |
| A | WO 97/39312 A1 (REGAL COMPONENTS AB [SE]; HORE DONALD LIONEL [GB]) 23 October 1997 (1997-10-23) * page 11, line 4 - line 20; figure 4a * | 1-14 | |
| A | WO 2020/073170 A1 (SIEMENS AG [DE]; WU MING CHUN [CN] ET AL.) 16 April 2020 (2020-04-16) * paragraph [0036] - paragraph [0037]; figures 1-4 * | 1-14 | |
| A | WO 2019/014690 A1 (AZOTEQ PTY LTD [ZA]) 17 January 2019 (2019-01-17) * paragraph [0044]; figure 6a * | 1-14 | |

TECHNICAL FIELDS SEARCHED (IPC)

H03K
G01D

The present search report has been drawn up for all claims

| Place of search | Date of completion of the search | Examiner |
|---|---|---|
| The Hague | 9 March 2022 | O'Reilly, Siobhan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 20 0538

This annex lists the patent family members relating to the patent documents cited in the above-mentioned European search report.
The members are as contained in the European Patent Office EDP file on
The European Patent Office is in no way liable for these particulars which are merely given for the purpose of information.

09-03-2022

| Patent document cited in search report | | Publication date | Patent family member(s) | | Publication date |
|---|---|---|---|---|---|
| US 4529967 | A | 16-07-1985 | NONE | | |
| WO 9739312 | A1 | 23-10-1997 | NONE | | |
| WO 2020073170 | A1 | 16-04-2020 | NONE | | |
| WO 2019014690 | A1 | 17-01-2019 | CN | 111094901 A | 01-05-2020 |
| | | | DE | 112018003575 T5 | 29-10-2020 |
| | | | US | 2020166376 A1 | 28-05-2020 |
| | | | WO | 2019014690 A1 | 17-01-2019 |